(19) Europäisches Patentamt
European Patent Office
Office européen des brevets

(11) **EP 1 470 573 B1**

(12) **EUROPÄISCHE PATENTSCHRIFT**

(45) Veröffentlichungstag und Bekanntmachung des Hinweises auf die Patenterteilung:
**01.07.2020** Patentblatt 2020/27

(51) Int Cl.:
*H01L 21/20* *(2006.01)* *H01L 21/762* *(2006.01)*
*H01L 23/00* *(2006.01)* *H01L 33/00* *(2010.01)*
*B23K 26/00* *(2014.01)* *C30B 29/40* *(2006.01)*
*C30B 33/00* *(2006.01)*

(21) Anmeldenummer: **03706270.0**

(22) Anmeldetag: **30.01.2003**

(86) Internationale Anmeldenummer:
**PCT/DE2003/000260**

(87) Internationale Veröffentlichungsnummer:
**WO 2003/065420 (07.08.2003 Gazette 2003/32)**

(54) **VERFAHREN ZUR HERSTELLUNG EINES HALBLEITERBAUELEMENTS**

METHOD FOR PRODUCING A SEMICONDUCTOR ELEMENT

PROCEDE DE FABRICATION D'UN COMPOSANT A SEMICONDUCTEUR

(84) Benannte Vertragsstaaten:
**DE**

(30) Priorität: **31.01.2002 DE 10203795**
**20.09.2002 DE 10243757**

(43) Veröffentlichungstag der Anmeldung:
**27.10.2004** Patentblatt 2004/44

(73) Patentinhaber: **OSRAM Opto Semiconductors GmbH**
**93055 Regensburg (DE)**

(72) Erfinder:
• **FEHRER, Michael**
**93077 Bad Abbach (DE)**
• **HAHN, Berthold**
**93155 Hemau (DE)**
• **HÄRLE, Volker**
**93164 Laaber (DE)**
• **KAISER, Stephan**
**93051 Regensburg (DE)**
• **OTTE, Frank**
**30419 Hannover (DE)**
• **PLÖSSL, Andreas**
**93053 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:

EP-A- 0 247 331 WO-A-98/14986
WO-A1-02/33760 US-A- 4 074 342
US-A- 4 749 840 US-A- 5 326 424
US-A- 5 892 288 US-A- 6 136 141
US-B1- 6 365 429

• **PATENT ABSTRACTS OF JAPAN vol. 2000, no. 10, 17. November 2000 (2000-11-17) & JP 2000 196197 A (XEROX CORP), 14. Juli 2000 (2000-07-14) -& US 6 365 429 B1 (M.A. KNEISSL ET AL.) 2. April 2002 (2002-04-02)**
• **WONG W S ET AL: "STRUCTURAL AND OPTICAL QUALITY OF GAN/METAL/SI HETEROSTRUCTURES FABRICATED BY EXCIMER LASER LIFT-OFF" APPLIED PHYSICS LETTERS, AMERICAN INSTITUTE OF PHYSICS. NEW YORK, US, Bd. 75, Nr. 13, 27. September 1999 (1999-09-27), Seiten 1887-1889, XP000875575 ISSN: 0003-6951**
• **TOET D ET AL: "THIN FILM TRANSISTORS FABRICATED IN PRINTED SILICON" JAPANESE JOURNAL OF APPLIED PHYSICS, Bd. 38, Nr. 10A, 1. Oktober 1999 (1999-10-01), Seiten L1149-L1152, XP000891134 TOKYO, JP ISSN: 1350-2409**
• **ANGELIS C T ET AL: "ELECTRICAL AND NOISE PROPERTIES OF THIN-FILM TRANSISTORS ON VERY THIN EXCIMER LASER ANNEALED POLYCRYSTALLINE SILICON FILMS" APPLIED PHYSICS LETTERS, AMERICAN INSTITUTE OF PHYSICS. NEW YORK, US, Bd. 74, Nr. 24, 14. Juni 1999 (1999-06-14), Seiten 3684-3686, XP000850574 ISSN: 0003-6951**

**Beschreibung**

Die Erfindung bezieht sich auf ein Verfahren zur Herstellung eines Halbleiterbauelements, bei dem eine Halbleiterschicht von einem Substrat durch Bestrahlen mit einem Laserstrahl getrennt wird.

Ein derartiges Verfahren kommt beispielsweise bei der Herstellung substratloser Lumineszenzdioden auf der Basis von GaN zum Einsatz. Solche Bauelemente enthalten einen Halbleiterkörper und ein Trägerteil, auf dem der Halbleiterkörper befestigt ist. Zur Herstellung des Halbleiterkörpers wird zunächst eine Halbleiterschicht auf einem geeigneten Substrat gefertigt, nachfolgend mit einem Träger verbunden und dann von dem Substrat abgelöst. Durch Zerteilen, beispielsweise Zersägen, des Trägers mit der darauf angeordneten Halbleiterschicht entsteht eine Mehrzahl von Halbleiterkörpern, die jeweils auf dem entsprechenden Trägerteil befestigt sind. Wesentlich ist hierbei, daß das zur Herstellung der Halbleiterschicht verwendete Substrat von der Halbleiterschicht entfernt wird und nicht zugleich als Träger bzw. Trägerteil im Bauelement dient.

Dieses Herstellungsverfahren hat den Vorteil, daß verschiedene Materialien für das Substrat und den Träger verwendet werden. Damit können die jeweiligen Materialien an die unterschiedlichen Anforderungen für die Herstellung der Halbleiterschicht einerseits und die Betriebsbedingungen andererseits weitgehend unabhängig voneinander angepaßt werden. So kann der Träger entsprechend seiner mechanischen, thermischen und optischen Eigenschaften unabhängig von den Anforderungen an das Substrat zum Fertigen der Halbleiterschicht gewählt werden.

Insbesondere die epitaktische Herstellung einer Halbleiterschicht stellt zahlreiche spezielle Anforderungen an das Epitaxiesubstrat. Beispielsweise müssen die Gitterkonstanten des Substrats und der aufzubringenden Halbleiterschicht aneinander angepaßt sein. Weiterhin sollte das Substrat den Epitaxiebedingungen, insbesondere Temperaturen bis über 1000°C, standhalten und für das epitaktische An- und Aufwachsen einer möglichst homogenen Schicht des betreffenden Halbleitermaterials geeignet sein.

Für die weitere Verarbeitung des Halbleiterkörpers und den Betrieb hingegen stehen andere Eigenschaften des Trägers wie beispielsweise elektrische und thermische Leitfähigkeit sowie Strahlungsdurchlässigkeit bei optoelektronischen Bauelementen im Vordergrund. Die für ein Epitaxiesubstrat geeigneten Materialien sind daher als Trägerteil im Bauelement oftmals nur bedingt geeignet. Schließlich ist es insbesondere bei vergleichsweise teuren Epitaxiesubstraten wie beispielsweise Siliziumkarbidsubstraten wünschenswert, die Substrate mehrmals verwenden zu können.

Für das genannte Herstellungsverfahren ist die Ablösung der Halbleiterschicht von dem Substrat wesentlich. Diese Ablösung kann durch Bestrahlung der Halbleiter-Substrat-Grenzfläche mit Laserstrahlung erreicht werden. Dabei wird die Laserstrahlung in der Nähe der Grenzfläche absorbiert und bewirkt dort eine Zersetzung des Halbleitermaterials.

Die Trennung der Halbleiterschicht von dem Substrat kann beispielsweise durch Laserablösen, wie in der Druckschrift WO 98/14986 beschrieben, erfolgen. Dabei wird für die Ablösung von GaN- und GaInN-Schichten von einem Saphirsubstrat die frequenzverdreifachte Strahlung eines Q-switch Nd:YAG-Lasers bei 355 nm verwendet. Das Saphirsubstrat ist für Strahlung dieser Wellenlänge transparent. Die Strahlungsenergie wird in einer etwa 100 nm dicken Grenzschicht am Übergang zwischen dem Saphirsubstrat und der GaN-Halbleiterschicht absorbiert. Bei Pulsenergien oberhalb von 200 mJ/cm$^2$ werden an der Grenzfläche Temperaturen von mehr als 850 °C erreicht. Die GaN-Grenzschicht zersetzt sich bei dieser Temperatur unter Freisetzung von Stickstoff, die Bindung zwischen der Halbleiterschicht und dem Substrat wird getrennt.

Bei einem derartigen Verfahren besteht die Gefahr, daß aufgrund unvollständiger Materialzersetzung bei der Ablösung der Halbleiterschicht Substratreste auf der Halbleiterschicht haften bleiben. Beispielsweise finden sich oftmals auf einer auf diese Art und Weise von einem Saphirsubstrat getrennten GaN-Schicht mikroskopische Saphirkörner, sogenannte "Abplatzer".

Der Durchmesser dieser Saphirrückstände liegt typischerweise zwischen 5 μm und 100 μm. Die Saphirrückstände erschweren die weitere Verarbeitung der Halbleiterschicht und erfordern aufgrund der hohen mechanischen und chemischen Resistenz von Saphir einen vergleichsweise großen Aufwand zu ihrer Entfernung. Dies kann dazu führen, daß nur Teile der abgelösten Halbleiterschicht weiterverwendet werden können oder sogar die gesamte Schicht unbrauchbar wird.

In der Regel ist eine mechanische Stabilisierung der abzulösenden Halbleiterschicht erforderlich, da die Schichtdicke so gering ist, daß ansonsten die Gefahr einer Beschädigung, insbesondere eines Bruchs oder Risses der Schicht, besteht. Zur mechanischen Stabilisierung ist beispielsweise eine stoffschlüssige Verbindung der Halbleiterschicht, die auch bereits teilprozessiert sein kann, mit dem Träger geeignet. Eine derartige Verbindung sollte zumindest so weit temperaturstabil sein, daß sie die bei nachfolgenden Fertigungsschritten auftretenden Temperaturen unbeschadet übersteht. Weiterhin sollte diese Verbindung auch bei Temperaturwechselbelastungen, die insbesondere im Betrieb des Bauelements auftreten können, stabil bleiben.

Zur Befestigung der Halbleiterschicht auf dem Träger werden oftmals Klebstoffe verwendet. Bei höheren elektrischen Leistungen können sich dabei Probleme aufgrund der begrenzten thermischen und elektrischen Leitfähigkeit von Klebstoffen ergeben. Die begrenzte thermische Beständigkeit solcher Klebstoffverbindungen limitiert zudem den zulässigen Temperaturbereich eines entsprechenden Bauelements und in der Folge die maximal mögliche Verlustleistung.

Die Druckschrift WO 98/14986 A beschreibt ein Verfahren zur Herstellung eines Halbleiterbauelements bei dem eine Halbleiterschicht von einem Substrat durch Bestrahlen mit einem Laser getrennt wird. Die Druckschrift Wong et al. Appl. Phys. Lett., Vol. 75, No. 13, Seiten 1887 bis 1889, beschreibt ein Verfahren zur Trennung eines Galliumnitridfilms von einem Saphirsubstrat mit Hilfe eines Lasers. Weiterhin beschreibt die Druckschrift JP 2000-196197 A ein Verfahren zum Transfer von Halbleiterschichten, die auf einem Wachstumssubstrat epitaktisch gewachsen sind, auf einen weiteren Träger mittels elektromagnetischer Strahlung.

Es ist Aufgabe der vorliegenden Erfindung, ein verbessertes Herstellungsverfahren für ein Halbleiterbauelement, bei dem eine Halbleiterschicht mittels Laserbestrahlung von einem Substrat getrennt wird, zu entwickeln.

Diese Aufgabe wird durch ein Verfahren nach dem Patentanspruch 1 gelöst. Vorteilhafte Weiterbildungen der Erfindung sind Gegenstand der abhängigen Ansprüche.

Erfindungsgemäß ist vorgesehen, eine Halbleiterschicht von einem Substrat durch Bestrahlung mit einem Laserstrahl zu trennen. Der Laserstrahl kann ein plateauartiges, insbesondere rechteckartiges oder trapezartiges Strahlprofil aufweisen. Durch dieses Strahlprofil wird die Anzahl der Substratrückstände auf der Halbleiterschicht gegenüber einem herkömmlichen Trennverfahren deutlich verringert.

Unter einem plateauartigen Strahlprofil ist eine transversale Intensitätsverteilung des Laserstrahls zu verstehen, die einen Zentralbereich mit einer im wesentlichen konstanten Intensitätsverteilung aufweist, an den sich jeweils eine Flanke mit abfallender Intensität anschließt. Vorzugsweise ist die relative Schwankung der Strahlintensität in dem Zentralbereich geringer als 5 Prozent.

Zur weiteren Verbesserung des Strahlprofils kann dem Laser ein Strahlhomogenisierer nachgeordnet sein. Weiterhin ist es zweckmäßig, zur Abbildung des Laserstrahls auf die Halbleiterschicht eine geeignete Optik, beispielsweise ein Linsensystem, das Korrekturlinsen, Abschwächer, Spiegel, Maskenstrukturen und/oder Projektive umfassen kann, zu verwenden. Auf diese Art und Weise ist es möglich, die zur Materialzersetzung erforderliche Energiedichte einzustellen, ohne das vorteilhafte Strahlprofil zu verschlechtern.

Die bei herkömmlichen Lasertrennverfahren verwendeten Laser weisen demgegenüber in der Regel ein gaußartiges Strahlprofil auf. Dies führt zu einer räumlich vergleichsweise stark variierenden, inhomogenen Feldverteilung auf der Halbleiter-Substrat-Grenzfläche und in der Folge zu einer unterschiedlich starken Materialzersetzung. Bei der nachfolgenden Ablösung der Halbleiterschicht besteht die Gefahr, daß an Stellen schwacher oder unvollständiger Materialzersetzung Substratrückstände auf der Halbleiterschicht haften bleiben.

Der Laserstrahl wird von einem Excimer-Laser erzeugt. Excimer-Laser weisen in der Regel ein plateauartiges, oftmals trapez- oder rechteckartiges Strahlprofil auf. Weiterhin liegt insbesondere bei Excimer-Lasern mit einer Edelgas-Halogen-Verbindung als Lasermedium die Emissionswellenlänge im ultravioletten Spektralbereich, der zur Ablösung von Nitridverbindungshalbleitern besonders geeignet ist. Zudem ist die Impulsspitzenleistung bei Excimer-Lasern, die typischerweise zwischen 1kW und 100 MW liegt, so groß, daß auch bei bei Maskenabbildungen des Laserstrahls und nach dem Durchgang durch eine Mehrzahl von Linsen die Energiedichte zur Materialzersetzung ausreicht.

Um die für die Materialzersetzung erforderliche Strahlintensität zu erreichen, ist für den Laser ein gepulster Betrieb zweckmäßig. Gegenüber einem Laser im Dauerstrichbetrieb wird so auch die Gefahr einer Überhitzung der abzulösenden Halbleiterschicht gemindert. Der Abtransport der durch die Laserbestrahlung entstehenden Wärme kann bei einem gepulsten Laser durch entsprechende Wahl von Impulsdauer und Impulsabstand optimal eingestellt werden.

Bei Halbleiterschichten mit größerer lateraler Ausdehnung ist es vorteilhaft, nebeneinander angeordnete Einzelbereiche der Halbleiterschicht nacheinander zu bestrahlen, um eine zu große Aufweitung der Strahlfläche zu vermeiden. Da bei gegebener Strahlleistung bzw. Energie des Laserimpulses mit steigender Strahlfläche die Intensität sinkt, kann bei zu starker Strahlaufweitung die Dekomposionsschwelle, d.h. die für die Materialzersetzung erforderliche Energiedichte, unterschritten und die vollständige Ablösung der Halbleiterschicht beeinträchtigt werden.

Hierbei ist es besonders vorteilhaft, den Laserstrahl und/oder das Substrat mit der darauf befindlichen Halbleiterschicht so zu führen, daß die bestrahlten Einzelbereiche eine flächenfüllende Gesamtanordnung ergeben. Dem entspricht zeitlich, d.h. über den Zeitraum der Bestrahlung, integriert eine annähernd konstante räumliche Intensitätsverteilung für den überwiegenden Teil der bestrahlten Fläche. Aufgrund dieser annähernd konstanten Intensitätsverteilung weist die abgelöste Halbleiterschicht eine vorteilhaft geringe Anzahl von Substratrückständen auf oder ist sogar rückstandsfrei. Für die genannte flächenfüllende Gesamtanordnung der bestrahlten Einzelbereiche ist ein plateauartiges, insbesondere rechteckartiges räumliches Strahlprofil besonders vorteilhaft.

Bei einer bevorzugten Weiterbildung der Erfindung weist der Laserstrahl am Ort der Halbleiterschicht bzw. der Halbleiter-Substrat-Grenzfläche eine Strahlfläche mit einer Längsabmessung und einer Querabmessung auf, wobei die Längsabmessung deutlich größer als die Querabmessung ist. Bevorzugt übersteigt die Längsabmessung die Querabmessung um einen Faktor 5 bis 10, so daß sich eine linienartige oder streifenartige Strahlfläche ergibt.

Die Halbleiterschicht wird während der Bestrahlung in paralleler Richtung zu der Querabmessung bewegt, so daß während der Bestrahlung die linien- oder streifenartige Strahlfläche die gesamte abzulösende Halbleiterschicht überstreicht. Über den Zeitraum der Bestrahlung integriert ergibt sich auch hier eine vorteilhaft konstante Intensitätsverteilung der bestrahlten Halbleiterschicht, wobei ein weiterer Vorteil darin besteht, daß eine einfache lineare Bewegung der Halbleiterschicht gegenüber dem Laserstrahl ausreicht. Es versteht sich, daß es sich hierbei um eine Relativbewegung zwischen Halbleiterschicht und Laserstrahl handelt, die sowohl durch eine Bewegung der Halbleiterschicht bei einem ortsfesten Laserstrahl als auch durch eine entsprechende Führung des Laserstrahls bei einer ortsfesten Halbleiterschicht realisiert werden kann.

Bei der Erfindung ist es vorteilhaft, den unmittelbaren Grenzflächenbereich zwischen Halbleiterschicht und Substrat mit der Laserstrahlung zu bestrahlen, so daß die Strahlungsenergie grenzflächennah absorbiert wird und dort zu einer Materialzersetzung führt. Dies kann dadurch erreicht werden, daß das Substrat für die Laserstrahlung durchlässig ist und die Halbleiterschicht durch das Substrat hindurch bestrahlt wird. Bei dieser Anordnung ist in der Regel die Absorption der Laserstrahlung in der Halbleiterschicht wesentlich größer als in dem Substrat, so daß der Laserstrahl das Substrat nahezu verlustfrei durchdringt und aufgrund der hohen Absorption grenzflächennah in der Halbleiterschicht absorbiert wird.

Es sei angemerkt, daß die Strahlungsabsorption nicht notwendigerweise am Ort der Materialzersetzung erfolgen muß. Die Materialzersetzung kann auch dadurch bewirkt werden, daß die Strahlung zunächst an einem anderen Ort absorbiert wird und nachfolgend ein Energietransport der absorbierten Strahlungsenergie an die Stelle der Materialzersetzung stattfindet. Gegebenenfalls könnte die Strahlung auch in dem Substrat absorbiert und nachfolgend die Strahlungsenergie zur Halbleiterschicht transportiert werden.

Bei der Herstellung eines Halbleiterbauelements wird eine Halbleiterschicht mittels eines Laserstrahls von einem Substrat getrennt, wobei vor der Trennung die Halbleiterschicht mit der von dem Substrat abgewandten Seite auf einen Träger aufgebracht, vorzugsweise aufgelötet, wird. Eine Lötverbindung zeichnet sich gegenüber herkömmlichen Klebstoffverbindungen durch eine hohe thermische und elektrische Leitfähigkeit aus.

Die Trennung selbst erfolgt vorzugsweise nach einem der bereits beschriebenen Verfahren. Es versteht sich, daß bei diesen zuvor beschriebenen Trennverfahren eine Lötverbindung zwar vorteilhaft ist, aber auch eine Klebeverbindung zwischen Träger und Halbleiterschicht im Rahmen der Erfindung liegt.

Als Lot wird vorzugsweise ein goldhaltiges Lot, beispielsweise ein Gold-Zinn-Lot, verwendet. Besonders bevorzugt sind hierbei Gold-Zinn-Lote mit einem hohen Goldanteil, beispielsweise zwischen 65 Gew% und 85 Gew%.

Die Schmelztemperatur eines solchen Lots beträgt typischerweise 278°C und ist somit größer als die Temperatur, die üblicherweise beim Verlöten eines elektrischen Bauelements entsteht. So ist beispielsweise die Löttemperatur beim Auflöten auf eine Leiterplatte in der Regel kleiner als 260°C. Damit wird verhindert, daß sich beim Einlöten des Bauelements der Halbleiterkörper von dem Trägerteil ablöst.

Weiterhin eignet sich als Lot beispielsweise ein Palladium-Indium-Lot, dessen Bestandteile sich bei einer vergleichsweise niedrigen Anfangstemperatur von etwa 200°C durchmischen, und das nach der Durchmischung eine vorteilhaft hohe Schmelztemperatur von über 660°C aufweist.

Eine derartige Verbindung kann beispielsweise dadurch hergestellt werden, daß auf der Halbleiterschicht eine Indiumschicht und auf dem Träger eine Palladiumschicht aufgebracht wird und nachfolgend der Träger und die Halbleiterschicht unter erhöhtem Druck bei einer Temperatur von etwa 200°C oder mehr zusammengefügt werden.

Selbstverständlich kann auch die Palladiumschicht auf der Halbleiterschicht und die Indiumschicht auf dem Träger aufgebracht sein. Zudem ist es vorteilhaft, zwischen der Halbleiterschicht und der Metallschicht weitere Schichten vorzusehen, die beispielsweise einen Schutz der Halbleiterschicht oder eine gute Haftung gewährleisten. Eine Schichtenfolge mit einer Titanschicht auf der Halbleiteroberfläche, nachfolgend einer Palladiumschicht und darauf einer Indiumschicht ist in Verbindung mit einer Palladiumschicht auf dem Träger besonders vorteilhaft.

Hinsichtlich eines geringen Kontaktwiderstands und vorteilhafter Löteigenschaften ist es zweckmäßig, die Halbleiterschicht auf der dem Träger zugewandten Seite vor dem Auflöten auf den Träger mit einer Kontaktmetallisierung zu versehen.

Hierfür eignet sich beispielsweise eine Platin-Gold-Metallisierung.

Der thermische Ausdehnungskoeffizient des Trägers $a_T$ ist auf den thermischen Ausdehnungskoeffizienten der Halbleiterschicht $a_{HL}$ und den thermischen Ausdehnungskoeffizienten des Substrats $a_S$ sowie auf das Strahlprofil und/oder die Pulslänge der Laserstrahlpulse derart abgestimmt gewählt, dass Verspannungen zwischen Substrat, Halbleiterschicht und Träger während der Herstellung reduziert werden. Allgemein ist unter einer Abstimmung der thermischen Ausdehnungskoeffizienten zu verstehen, daß deren Differenz so klein ist, daß in dem bei der Herstellung auftretenden bzw. im Betrieb vorgesehenen Temperaturbereich keine Schäden an der Halbleiterschicht und dem Träger entstehen. Die Gefahr von Rißbildungen im Träger und in der Halbleiterschicht wird damit stark herabgesetzt.

Es wurde diesbezüglich im Rahmen der Erfindung beobachtet, daß sich die Spotprofile (Intensitätsprofile) der zur Ablösung der Halbleiterschichten verwendeten Laserpulse oft nach dem Laserbeschuß auf der Halbleiteroberfläche erkennen lassen. Im Fall der Ablösung von GaN-Halbleiterschichten bleibt etwa nach der Dissoziation des GaN metallisches Gallium auf der Oberfläche zurück. Untersuchungen der Erfinder ergaben weiter, daß an den Rändern der Laserspots Risse im GaN-Material entstehen, die bei einer weiteren Prozessierung des Materials zum lokalen Abplatzen der Halbleiterschicht von dem darunterliegenden Träger führen.

Es wurde nun gefunden, daß hierfür vor allem thermische Effekte verantwortlich sind. Um etwa bei einer GaN-Halbleiterschicht eine Dissoziation des GaN zu erreichen, müssen lokal Temperaturen von etwa 800 °C bis 1000 °C in der Halbleiterschicht erreicht werden. Fällt die Energiedichte am Rand des Laserspots stark ab, so können im Inneren des Laserspots die für die Ablösung erforderlichen Temperaturen erreicht werden, während das Halbleitermaterial in unmittelbarer Umgebung des Laserspots vergleichsweise kalt bleibt.

Zwar fallen die an der GaN-Oberfläche erreichten Temperaturen über die Schichtdicke der Halbleiterschicht deutlich ab, doch werden an der Trägerseite der Halbleiterschicht im Bereich des Laserspots noch Temperaturen von bis zu 400 °C erreicht. Somit entstehen aufgrund der lokal unterschiedlichen Temperaturen im Laserspot und außerhalb des Spots sowohl in der Halbleiterschicht als auch im Träger aufgrund der im allgemeinen unterschiedlichen thermischen Ausdehnungskoeffizienten des Halbleitermaterials und des Trägermaterials Zugverspannungen, die zur beobachteten Ausbildung von Rissen im Halbleitermaterial an den Laserspoträndern führen können.

Bei der weiteren Prozessierung von derartigen mit Rissen versehenen Halbleiterschichten entsteht beispielsweise das Problem, daß Säure entlang der Risse unter die Halbleiterschicht kriechen kann und dort etwa eine Bondmetallisierung zerstört.

Bei der Erfindung werden bevorzugt spezielle, in ihren thermischen Eigenschaften adaptierte Trägermaterialien verwendet. Dabei werden für die Wahl des thermischen Ausdehnungskoeffizienten des Trägers $a_T$ insbesondere zwei Prozeßschritte, nämlich der Bondprozeß und die Laserbestrahlung, in Betracht gezogen.

Beim Bondprozeß wird das Substrat mit der darauf epitaxierten Halbleiterschicht zusammen mit dem Träger ganzflächig auf eine Temperatur von typischerweise etwa 400 °C aufgeheizt und anschließend wieder allmählich auf Zimmertemperatur abgekühlt. In diesem Schritt ist der Verspannungshaushalt des Schichtpakets Substrat/Halbleiterschicht/Träger im wesentlichen durch das Substrat und den Träger bestimmt.

Weichen die thermischen Ausdehnungskoeffizienten von Substrat und Träger, $a_S$ und $a_T$, zu stark voneinander ab, so kann sich das Schichtpaket beim Abkühlen verbiegen. Es können sich auch Risse im Träger bilden, so daß das entstehende Chip keine ausreichende Stabilität mehr aufweist.

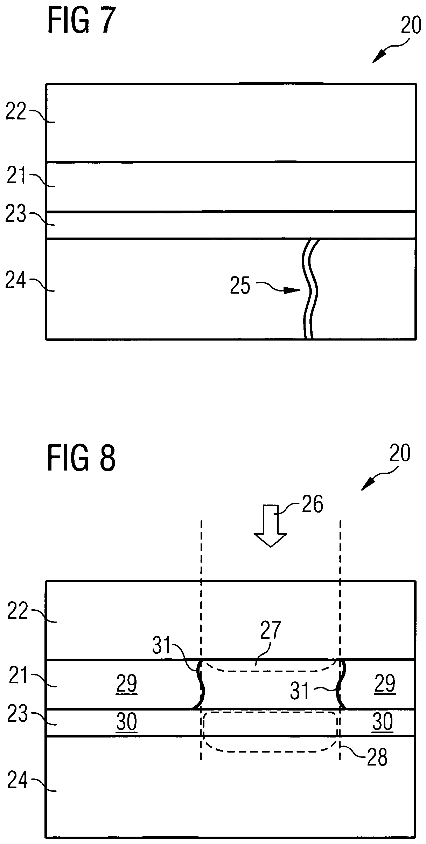

Dieses Problem ist beispielhaft in Fig. 7 illustriert. Bei dem dort schematisch dargestellten Schichtpaket 20 ist eine GaN-Halbleiterschicht 21 auf einem Saphirsubstrat 22 aufgewachsen. Die von dem Substrat 22 abgewandte Seite der Halbleiterschicht 21 ist mit einer Kontaktmetallisierung 23 versehen. Auf der Kontaktmetallisierung 23 ist als Träger 24 ein Bondwafer bei einer Temperatur von etwa 400 °C aufgelötet.

Ist nun der thermische Ausdehnungskoeffizient $a_T$ des Trägers wesentlich kleiner als der thermische Ausdehnungskoeffizient $a_S$ des Saphirsubstrats, so können sich bei diesem Bondschritt Risse 25 im Träger 24 bilden.

Bei der Laserbestrahlung wird das Halbleitermaterial innerhalb des Laserspots lokal auf eine Temperatur oberhalb der Zersetzungstemperatur des Halbleitermaterials aufgeheizt, während das Substratmaterial aufgrund seiner wesentlich geringeren Absorption der Laserstrahlung kalt bleibt. Da durch die Laserbestrahlung die Bindung zwischen dem Halbleitermaterial und dem Substrat durch Dissoziation aufgehoben wird, bestimmt der Unterschied der thermischen Ausdehnungskoeffizienten von Halbleiterschicht und Träger, $a_{HL}$ und $a_T$, den Verspannungshaushalt im Schichtpaket. Bei einem großem Unterschied zwischen $a_{HL}$ und $a_T$ können Zugverspannungen entstehen, die zur Rißbildung im Halbleitermaterial an den Stellen der Spoträder führen können.

Figur 8 erläutert die Problematik wieder für die Ablösung einer GaN-Schicht 21 von einem Saphirsubstrat 22. Bei Bestrahlung des Schichtpakets 20 mit kurzen Laserpulsen 26 eines Excimerlasers wird die Laserstrahlung in einem grenznahen Bereich 27 der GaN-Schicht 21 absorbiert und erzeugt dort Temperaturen von 800 °C bis 1000 °C. Auf der dem Substrat abgewandeten Seite der Halbleiterschicht 21 und im angrenzenden Bereich 28 werden noch Temperaturen bis zu etwa 400 °C erreicht. Außerhalb des Laserspots bleibt die GaN-Schicht 21 und die Kontaktmetallisierung 23 vergleichsweise kalt. Die Temperatur in den lateral unmittelbar an den Laserspot angrenzenden Bereichen 29 und 30 liegt typischerweise deutlich unterhalb von 300 °C. Bei stark unterschiedlichen thermischen Ausdehnungskoeffizienten zwischen der GaN-Schicht 21 und dem Material des Trägers 24 bzw. des Bondwafers können so Risse 31 in der epitaktischen GaN-Schicht 21 entstehen.

Um Rißbildungen im Träger und in der epitaktischen Halbleiterschicht zu vermeiden, muß daher ein Trägermaterial gewählt werden, dessen thermischer Ausdehnungskoeffizient $a_T$ sich weder von dem thermischen Ausdehnungskoeffizienten des Substrats $a_S$ noch von dem thermischen Ausdehnungskoeffizienten der Halbleiterschicht $a_{HL}$ zu stark unterscheidet. In die Wahl eines geeigneten thermischen Ausdehnungskoeffizienten $a_T$ geht auch, wie weiter unten noch er genauer erläutert wird, das Strahlungsprofil und die Pulslänge der Laserstrahlung ein.

Bei einer bevorzugten Ausgestaltung des erfindungsgemäßen Verfahrens ist vorgesehen, daß der thermische Ausdehnungskoeffizient des Trägers $a_T$ näher an dem thermischen Ausdehnungskoeffizienten der Halbleiterschicht $a_{HL}$ als an dem thermischen Ausdehnungskoeffizienten $a_S$ des Substrats gewählt wird. Mit einer derartigen Wahl kann die Ausbildung von Rissen in der Halbleiterschicht wirkungsvoll reduziert oder ganz vermieden werden.

Dabei ist es zweckmäßig, wenn sich der thermische Ausdehnungskoeffizient des Trägers $a_T$ um 45% oder weniger, bevorzugt um 40% oder weniger von dem thermischen Ausdehnungskoeffizienten $a_S$ des Substrats unterscheidet.

Insbesondere ist für ein Saphirsubstrat mit einem thermischen Ausdehnungskoeffizienten

$$a(Al_2O_3) = 7,5 * 10^{-6} K^{-1}$$

ein Trägermaterial bevorzugt, dessen thermischer Ausdehnungskoeffizient $a_T$ zwar unterhalb von $a(Al_2O_3)$ liegt, aber größer als $4,125 * 10^{-6} K^{-1}$, insbesondere größer als $4,5 * 10^{-6} K^{-1}$ ist.

In Bezug auf die thermischen Eigenschaften der Halbleiterschicht unterscheidet sich der thermische Ausdehnungskoeffizient des Trägers $a_T$ um 35% oder weniger von dem thermischen Ausdehnungskoeffizienten $a_{HL}$ der Halbleiterschicht. Bevorzugt unterscheidet sich der thermische Ausdehnungskoeffizient des Trägers $a_T$ um 25% oder weniger von dem thermischen Ausdehnungskoeffizienten $a_{HL}$ der Halbleiterschicht. Insbesondere bei Ablösung einer Nitridverbindungshalbleiterschicht wie zum Beispiel einer GaN-basierten Halbleiterschicht mit einem thermischen Ausdehnungskoeffizienten

$$a(GaN) = 4,3 * 10^{-6} K^{-1}$$

ist ein Trägermaterial bevorzugt, dessen thermischer Ausdehnungskoeffizient $a_T$ zwar größer als $a(GaN)$, aber kleiner als $5,8 * 10^{-6} K^{-1}$, insbesondere kleiner als $5,6 * 10^{-6} K^{-1}$ ist.

Für die Ablösung einer Nitridverbindungshalbleiterschicht, etwa einer GaN- oder GaInN-Schicht von einem Saphirsubstrat ist somit ein Träger mit einem thermischen Ausdehnungskoeffizienten zwischen $4,125 * 10^{-6} K^{-1}$ und $5,8 * 10^{-6} K^{-1}$, insbesondere zwischen $4,5 * 10^{-6} K^{-1}$ und $5,6 * 10^{-6} K^{-1}$ besonders gut geeignet.

Bei einer derartigen Wahl des thermischen Ausdehnungskoeffizienten $a_T$ kann für die Trennung der Halbleiterschicht von dem Substrat eine große Pulslänge der Laserstrahlpulse, insbesondere eine Pulslänge größer als 15 ns gewählt werden, ohne daß sich eine Rißbildung in der Halbleiterschicht ergibt.

Gemäß der Erfindung enthält der Träger Molybdän oder Wolfram. Der thermische Ausdehnungkoeffizient von Molybdän

$$a(Mo) = 5,21 * 10^{-6} K^{-1}$$

liegt deutlich näher an $a(GaN)$ als beispielsweise der thermische Ausdehnungkoeffizient von GaAs mit $a(GaAs) = 6,4 * 10^{-6} K^{-1}$. Bei dem Schichtpaket Molybdän-Bondwafer/GaN-Halbleiterschicht/Saphir-Substrat ist die vorgenannte Problematik der Rißbildung beim Laserbeschuß deutlich reduziert. Molybdän ist zudem stabil genug, so daß beim Bonden oder beim Abkühlen von der Bondtemperatur auf Zimmertemperatur keine Risse entstehen.

Weiterhin kann der Träger eine Eisen-Nickel-Kobalt-Legierung enthalten, die ebenfalls einen günstigen thermischen Ausdehnungskoeffizienten

$$a(Fe-Ni-Co) = 5,1 * 10^{-6} K^{-1}$$

aufweist.

Auch Wolfram mit einem thermischen Ausdehnungkoeffizienten

$$a(Wo) = 4,7 * 10^{-6} K^{-1}$$

hat sich als vorteilhaftes Material für den Träger herausgestellt. Allgemein zeigt sich, daß die metallische Trägermaterialien aufgrund ihrer Zähigkeit während des Bondprozesses und während des Abkühlens auf Zimmertemperatur kaum rißempfindlich sind.

Es ist beispielsweise möglich, bei der Auswahl des thermischen Ausdehnungskoeffizienten des Trägers eine größere Toleranz bezogen auf den thermischen Ausdehnungskoeffizienten der Halbleiterschicht zuzulassen, wenn kürzere Laserpulse verwendet werden. So kann sich nach der Erfindung der thermische Ausdehnungskoeffizient des Trägers $a_T$ um 35% oder mehr von dem thermischen Ausdehnungskoeffizienten $a_{HL}$ der Halbleiterschicht unterscheiden, wenn für die Trennung der Halbleiterschicht von dem Substrat eine kleine Pulslänge der Laserstrahlpulse, insbesondere eine Pulslänge kleiner als etwa 15 ns gewählt wird. Dies gestattet insbesondere die Verwendung eines GaAs-Bondwafers mit $a(GaAs) = 6,4 * 10^{-6} K^{-1}$ bei kurzen Pulsdauern.

Bei einer bevorzugten Weiterentwicklung des erfindungsgemäßen Verfahrens ist vorgesehen, die genannten Träger mit einem angepaßten thermischen Ausdehnungskoeffizienten bei dem oben beschriebenen Ablöseverfahren mit einem Laserstrahl, der ein plateauartiges Strahlprofil aufweist, zu verwenden. Dies schließt die beschriebene Verwendung eines Excimerlaser, zum Beispiel mit XeF, XeBr, XeCl, KrCl oder KrF als laseraktivem Medium, ein. Weiterhin schließt dies insbesondere auch die beschriebene Ausgestaltungen wie die Ausbildung eines rechteckartigen oder trapezartigen räumliches Strahlungsprofils, die Auswahl einer Emissionswellenlänge zwischen 200 nm und 400 nm, die Nachordnung geeigneten Optik und/oder eines Strahlhomogenisierers oder die aufeinanderfolgende Bestrahlung des Substrats in mehreren Einzelbereichen der Halbleiterschicht ein.

Weiterhin kann wie bereits beschrieben die Halbleiterschicht vor dem Ablösen mittels eines Gold-Zinn-Lots, bevorzugt mit einem hohen Goldanteil von 65 Gew-% bis 85 Gew-% oder mit einem Palladium-Indium-Lot auf den Träger gelötet werden, wobei optional zuvor noch auf die dem Substrat abgewandte Seite der Halbleiterschicht eine Metallisierung, die zum Beispiel Gold und/oder Platin enthält, aufgebracht werden kann.

Als weiterer Vorteil des erfindungsgemäßen Verfahrens hat sich herausgestellt, daß durch die Verwendung thermisch angepaßter Träger auch das Problem der unzureichenden Haftung zwischen Halbleiterschicht und Träger gelöst wird, das in der Vergangenheit beispielsweise bei epitaktischen GaN-Schichten in Verbindung mit GaAs-Bondwafern als Träger beobachtet wurde. Die Kontrolle des Verspannungshaushaltes im gesamten Schichtpaket nach der vorliegenden Erfindung schließt auch die Bondmetallisierung mit ein und schafft dadurch hinsichtlich der genannten Haftungsproblematik wirkungsvoll Abhilfe.

Die Erfindung eignet sich insbesondere für Halbleiterschichten, die einen Nitridverbindungshalbleiter enthalten. Nitridverbindungshalbleiter sind beispielsweise Nitridverbindungen von Elementen der dritten und/oder fünften Hauptgruppe des Periodensystems der chemischen Elemente wie GaN, AlGaN, InGaN, AlInGaN, InN oder AlN. Die Halbleiterschicht kann dabei auch eine Mehrzahl von Einzelschichten verschiedener Nitridverbindungshalbleiter umfassen. So kann die Halbleiterschicht zum Beispiel einen herkömmlichen pn-Übergang, eine Doppelheterostruktur, eine Einfach-Quantentopfstruktur (SQW-Struktur) oder eine Mehrfach-Quantentopfstruktur (MQW-Strukur) aufweisen. Solche Strukturen sind dem Fachmann bekannt und werden daher an dieser Stelle nicht näher erläutert. Bevorzugt werden derartige Strukturen bei optoelektronischen Bauelementen wie Lichtemissionsdioden wie Leuchtdioden (LEDs) oder Laserdioden verwendet.

Es sei angemerkt, daß sich beispielsweise insbesondere für Nitridverbindungshalbleiter ein Träger eignet, der Galliumarsenid, Germanium, Molybdän, Silizium oder eine Legierung, zum Beispiel auf der Basis von Eisen, Nickel und/oder Kobalt, enthält. Bevorzugt werden Träger auf der Basis der oben genannten vorteilhaften Materialien Molybdän oder Wolfram verwendet. Weiterhin wird der Träger beispielsweise auf der Basis einer Eisen-Nickel-Kobalt-Legierung verwendet.

Als Substrat für die epitaktische Herstellung von Nitridverbindungshalbleiterschichten eignen sich beispielsweise Silizium-, Siliziumkarbid- oder Aluminiumoxid- bzw. Saphirsubstrate, wobei Saphirsubstrate vorteilhafterweise für die zur Abtrennung der Halbleiterschicht verwendete Laserstrahlung, insbesondere im ultravioletten Spektralbereich, durchlässig sind. Dies ermöglicht bei der Ablösung der Halbleiterschicht eine Bestrahlung der Halbleiterschicht durch das Substrat hindurch.

Das erfindungsgemäße Verfahren kann mit Vorteil bei Dünnschichtchips angewandt werden, die typischerweise eine Halbleiterschicht mit eine Dicke unterhalb von etwa 50 $\mu$m aufweist. Der Dünnschichtchip kann beispielsweise ein optoelektronischer Chip, insbesondere ein strahlungserzeugender Chip wie zum Beispiel ein Lumineszenzdiodenchip sein.

Weitere Merkmale, Vorzüge und Zweckmäßigkeiten der Erfindung ergeben sich aus der Beschreibung der nachfolgenden drei Ausführungsbeispiele der Erfindung in Verbindung mit den Figuren 1 bis 8.

Es zeigen:

　　　Figur 1a bis 1e eine schematische Darstellung eines ersten Ausführungsbeispiels eines erfindungsgemäßen Verfahrens anhand von fünf Zwischenschritten,

　　　Figur 2a und 2b jeweils eine schematische Darstellung zweier Varianten eines zweiten Ausführungsbeispiels eines erfindungsgemäßen Verfahrens,

　　　Figur 3a und 3b eine schematische Darstellung eines Strahlprofils des Laserstrahls bei dem in Figur 2a gezeigten Verfahren,

　　　Figur 4 eine schematische Darstellung der resultierenden Intensitätsverteilung bei dem in Figur 2a dargestellten Verfahren,

　　　Figur 5 eine schematische Darstellung eines dritten Ausführungsbeispiels eines erfindungsgemäßen Verfahrens,

　　　Figur 6a bis 6c eine beispielhafte schematische Darstellung eines Herstellungsverfahrens bei Verwendung gaußförmiger Intensitätsverteilungen,

　　　Figur 7 eine beispielhafte schematische Darstellung zur Erläuterung der Entstehung von Rissen im dem Träger und

　　　Figur 8 eine beispielhafte schematische Darstellung zur Erläuterung der Entstehung von Rissen in der Halbleiterschicht.

Gleiche oder gleich wirkende Elemente sind in den Figuren mit denselben Bezugszeichen versehen.

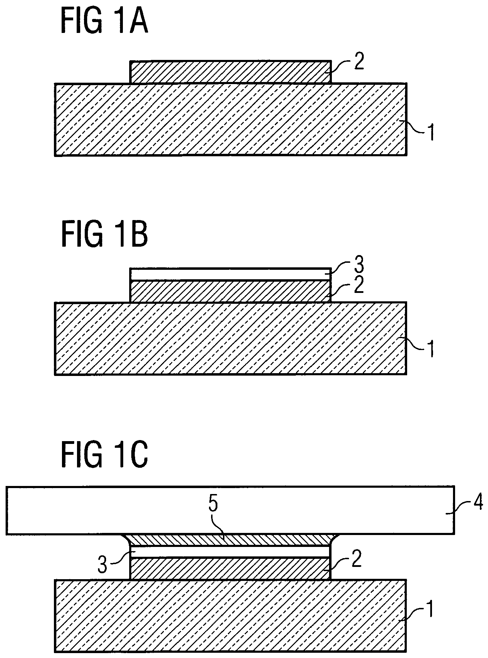

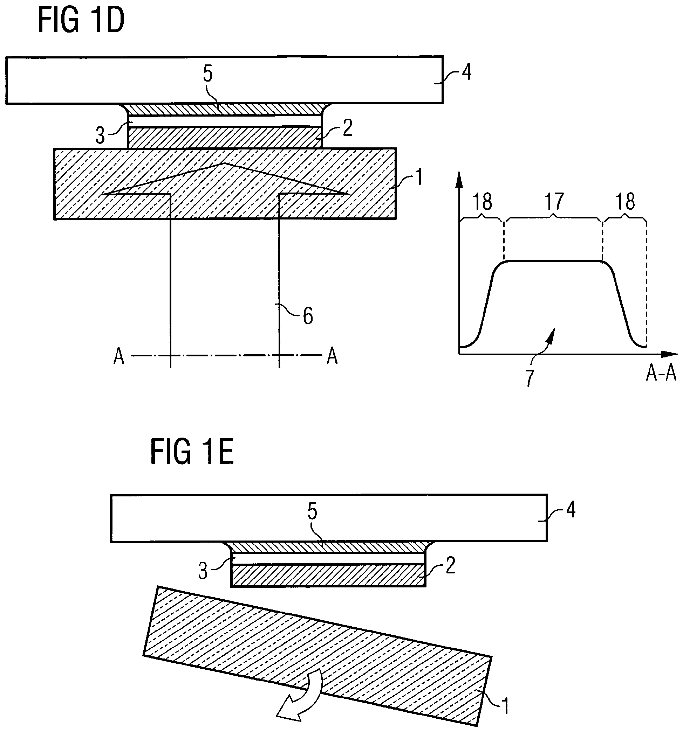

Im ersten Schritt des in Figur 1 dargestellten Verfahrens, Figur 1a, wird auf ein Substrat 1 eine Halbleiterschicht 2 aufgebracht. Dies kann eine Nitridverbindungshalbleiterschicht, beispielsweise eine InGaN-Schicht, sein, die epitaktisch auf ein Saphirsubstrat aufgewachsen wird. Weitergehend kann die Halbleiterschicht 2 auch eine Mehrzahl von Einzelschichten, die zum Beispiel GaN, AlN, AlGaN, InGaN, InN oder InAl-

GaN enthalten können und nacheinander auf das Substrat 1 aufgewachsen werden, umfassen.

Im nächsten Schritt, Figur 1b, wird die Halbleiterschicht 2 auf der von dem Substrat abgewandten Seite mit einer Kontaktmetallisierung 3 versehen. Mittels der Kontaktmetallisierung 3 wird ein geringer Kontaktwiderstand zwischen der Halbleiterschicht 2 und einem in einem späteren Verfahrensschritt anzubringenden elektrischen Anschluß, beispielsweise einem Anschlußdraht, erreicht. Zudem verbessert die Kontaktmetallisierung 3 die Löteigenschaften der Halbleiterschicht 2.

Die Kontaktmetallisierung 3 kann beispielsweise in Form einer dünnen gold- und/oder platinhaltigen Schicht aufgedampft oder aufgesputtert werden.

Nachfolgend wird auf die Kontaktmetallisierung 3 ein Träger 4 aufgelötet, Figur 1c. Als Lot 5 wird vorzugsweise ein goldhaltiges Lot verwendet, beispielsweise ein Gold-Zinn-Lot mit einem Goldanteil zwischen 65 Gew% und 85 Gew%, bevorzugt 75 Gew%. Eine solche Lötverbindung zeichnet sich durch eine hohe thermische Leitfähigkeit und eine hohe Stabilität unter Temperaturwechselbelastungen aus.

Die Lötverbindung kann bei einer Fügetemperatur von 375°C ausgebildet werden, wobei ein vergleichsweise geringer Fügedruck, der kleiner als 1,0 bar ist, nötig ist. Dieser geringe Fügedruck ermöglicht auch bei sehr dünnen Halbleiterschichten eine Verbindung mit dem Träger 4 ohne mechanische Schädigung der Halbleiterschicht 2.

Als Träger 4 kann beispielsweise ein GaAs-Wafer verwendet werden, der einen ähnlichen thermischen Ausdehnungskoeffizienten wie Saphir aufweist.

Gemäß dem ersten Ausführungsbeispiel der Figuren 1a bis 1e ist ein Träger 4 in Form eines Bondwafers aus Molybdän vorgesehen. Die thermischen Ausdehnungskoeffizienten des Bondwafers $a(Mo) = 5,21 * 10^{-6}$ $K^{-1}$ und des Saphirsubstrats $a (Al_2O_3) = 7,5 * 10^{-6}$ $K^{-1}$ liegen relativ nahe beieinander, so daß thermisch induzierte Verspannungen in der Halbleiterschicht 2 vorteilhafterweise gering gehalten werden. Darüber hinaus ist Molybdän ausreichend zäh, so daß beim Bonden und beim Abkühlen von der Bondtemperatur auf Zimmertemperatur keine Risse im Molybdän-Bondwafer entstehen.

Statt eines GaAs-Wafers kann beispielsweise auch ein Ge-Wafer verwendet werden. Der thermische Ausdehnungskoeffizient von Germanium ist ähnlich dem von GaAs so daß sich diesbezüglich kaum Unterschiede ergeben. Ein Ge-Wafer weist jedoch gegenüber einem GaAs-Wafer den Vorteil auf, daß er leichter gesägt werden kann, wobei insbesondere keine arsenhaltigen, giftigen Sägeabfälle anfallen. Weiterhin sind Ge-Wafer mechanisch stabiler. So wird beispielsweise mit einem $200\mu m$ dicken Ge-Wafer bereits eine ausreichende Stabilität erreicht, wohingegen die Dicke eines entsprechenden GaAs-Wafers größer als $600\mu m$ ist. Vorteilhafterweise ist es hierbei auch nicht erforderlich, den Ge-Wafer in einem weiteren Verfahrensschritt durch Schleifen abzudünnen. Schließlich sind Ge-Wafer in der Regel deutlich kostengünstiger als GaAs-Wafer.

Beispielsweise wird in Verbindung mit einem Ge-Wafer ein goldhaltiges Lot oder Gold selbst als Lot verwendet. Hiermit wird eine besonders feste Verbindung mit der Halbleiterschicht erreicht. Besonders bevorzugt wird ein goldbedampfter Ge-Wafer, der optional mit einer AuSb-Oberflächenschicht versehen sein kann, verwendet.

Im darauffolgenden Schritt, Figur 1d, wird die Halbleiterschicht 2 durch das Substrat 1 hindurch mit einem Laserstrahl 6 mit einem plateauförmigen Strahlprofil 7 bestrahlt. Die Strahlungsenergie wird vorwiegend in der Halbleiterschicht 2 absorbiert und bewirkt an der Grenzfläche zwischen der Halbleiterschicht 2 und dem Substrat 1 eine Materialzersetzung, so daß nachfolgend das Substrat 1 abgehoben werden kann.

Wesentlich ist bei der Erfindung, daß das Strahlprofil und die eingekoppelte Strahlleistung so bemessen sind, daß lokal an der Grenzfläche zwischen dem Substrat 1 und der Halbleiterschicht 2 eine hohe, zur Materialzersetzung ausreichende Temperatur entsteht, die über die Schichtdicke der Halbleiterschicht so weit abfällt, daß die Verbindung 5 zwischen dem Träger 4 und dem der Halbleiterschicht nicht beeinträchtigt wird, beispielsweise aufschmilzt.

Vorteilhafterweise werden die aufgrund der Materialzersetzung auftretenden starken mechanischen Belastungen von der Lotschicht aufgenommen, so daß sogar Halbleiterschichten mit einer Dicke von wenigen Mikrometern zerstörungsfrei vom Substrat abgelöst werden können.

Das transversale Strahlprofil 7 des Laserstrahl 6 ist ebenfalls in Figur 1d dargestellt. Aufgetragen ist die Strahlintensität längs der Linie A-A. Das Strahlprofil 7 weist einen zentralen Bereich 17 auf, in dem die Intensität im wesentlichen konstant ist. Lateral schließen sich an diesen Zentralbereich 17 Flankenbereiche 18 an, in denen die Intensität steil abfällt. Je nach Art des Abfalls gleicht das Strahlprofil einem Trapez (linearer Abfall) oder bei sehr steilem Abfall einem Rechteck.

Als Strahlungsquelle eignet sich besonders ein XeF-Excimer-Laser. Aufgrund der hohen Verstärkung und der typischen Resonatorgeometrie von Excimer-Lasern ist das räumliche Strahlprofil plateauförmig und daher besonders für die Erfindung geeignet. Weiterhin ist die hohe Impulsspitzenintensität von Excimer-Lasern in einem Bereich von 1 kW bis 100 MW sowie die Emissionswellenlänge im ultravioletten Spektralbereich bei der Erfindung vorteilhaft.

Die Laserstrahlung wird mittels einer geeigneten Optik durch das Substrat hindurch auf die Halbleiterschicht 2 fokussiert und weist dort eine typische Strahlfläche von etwa 1 mm x 2 mm oder mehr auf. Die Intensitätsverteilung innerhalb der Strahlfläche ist weitgehend homogen, wobei eine Energiedichte zwischen 200 $mJ/cm^2$ und 800 $mJ/cm^2$ erreicht wird. Diese Energiedichte in Verbindung mit einer homogenen Intensitätsverteilung ermöglicht eine rückstandsfreie Trennung der Halbleiterschicht von dem Substrat.

Dies wurde beispielhaft an einer InGaN-Schicht auf einem Saphirsubstrat experimentell nachgewiesen. Im einzelnen wurde die InGaN-Halbleiterschicht mit einem gepulsten Laserstrahl eines XeF-Excimer-Lasers mit einer Wellenlänge von 351 nm und einer Pulsdauer von 25 ns bestrahlt. Während das Saphirsubstrat für Strahlung dieser Wellenlänge transparent ist, wird sie in der InGaN-Halbleiterschicht stark absorbiert. Eine dünne Grenzschicht am Übergang zum Substrat heizt sich durch den Energieeintrag auf Temperaturen von 800 °C bis 1000 °C auf. Bei dieser Temperatur zersetzt sich das Halbleitermaterial im Laserspot unter Freisetzung von Stickstoff und trennt die Bindung zwischen der Halbleiterschicht 14 und dem Substrat 12.

Alternativ kann eine vergleichbare rückstandsfreie Trennung mit einem KrF-Excimer-Laser durchgeführt werden. Die Emissionswellenlänge liegt mit etwa 248 nm weiter im ultravioletten Spektralbereich. Auch bei größeren Strahlquerschnitten mit einer Abmessung von 30 mm x 10 mm reicht hierbei die Energiedichte, die entsprechend zwischen 150 mJ/cm$^2$ und 600 mJ/cm$^2$, vorzugsweise zwischen 150 mJ/cm$^2$ und 450 mJ/cm$^2$, liegt, zur rückstandsfreien Trennung der Halbleiterschicht vom Substrat aus. Weiterhin haben sich XeBr-, XeCl- und KrCl-Excimer-Laser mit einer Emissionswellenlänge von etwa 282 nm, 308 nm bzw. 222 nm für die Erfindung als geeignet erwiesen.

Nach der Bestrahlung mit dem Laserstrahl kann das Substrat 1 abgehoben werden, Figur 1e, wobei die Halbleiterschicht 2 weitgehend ohne Substratrückstände auf dem Träger 4 verbleibt und weiterverarbeitet werden kann.

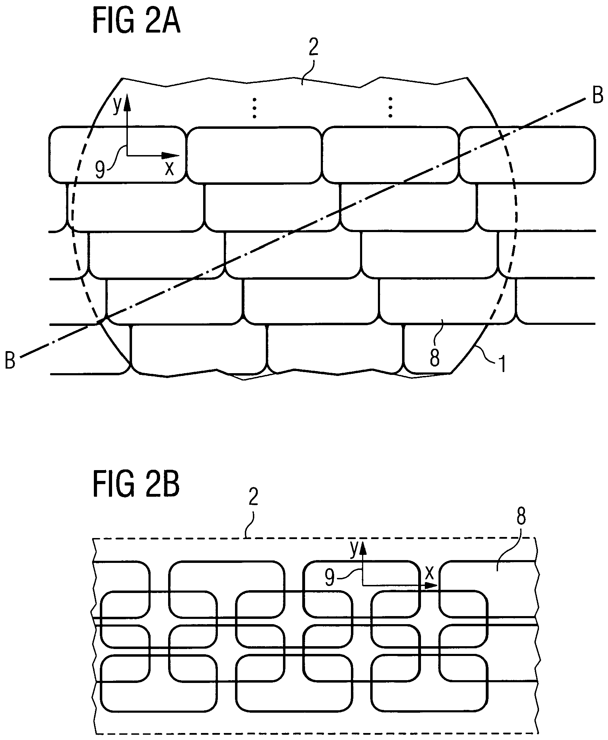

In Figur 2a ist ein zweites Ausführungsbeispiel eines erfindungsgemäßen Verfahrens gezeigt. Im Unterschied zu dem in Figur 1 dargestellten Verfahren werden hier Einzelbereiche 8 der Halbleiterschicht 2 nacheinander dem Laserstrahl ausgesetzt. Die annähernd rechteckförmigen Einzelbereiche 8 sind flächenfüllend und leicht überlappend angeordnet. Der Überlapp dient dabei zum Ausgleich des Intensitätsabfalls in den Randbereichen 18 des Strahlprofils 7. Die Einzelbereiche sind weiterhin matrixartig angeordnet, wobei eine Versetzung der Matrixzeilen gegeneinander hinsichtlich einer möglichst homogenen Intensitätsverteilung vorteilhaft ist. Eine alternative Anordnung der Einzelbereiche 8 ist in schematisch Figur 2b dargestellt.

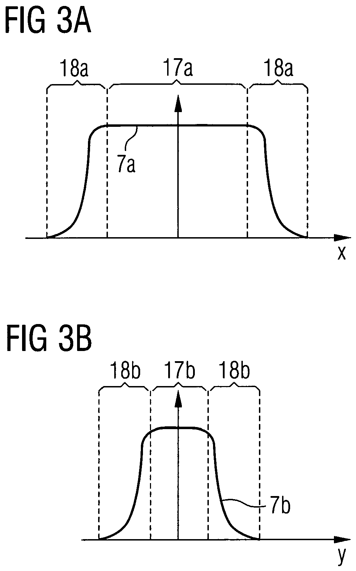

Das Strahlprofil des Laserstrahls innerhalb des Einzelbereichs 8 ist in Figur 3a und 3b dargestellt. In Figur 3a ist die Intensität längs der X-Achse des in Figur 2a bzw. 2b eingezeichneten Achsenkreuzes 9 aufgetragen, Figur 3b zeigt den entsprechenden Intensitätsverlauf längs der Y-Achse. Beide Profile sind plateauartig und weisen einen Zentralbereich 17a, 17b auf, an den sich Flanken 18a, 18b mit einem steilen Intensitätsabfall anschließen.

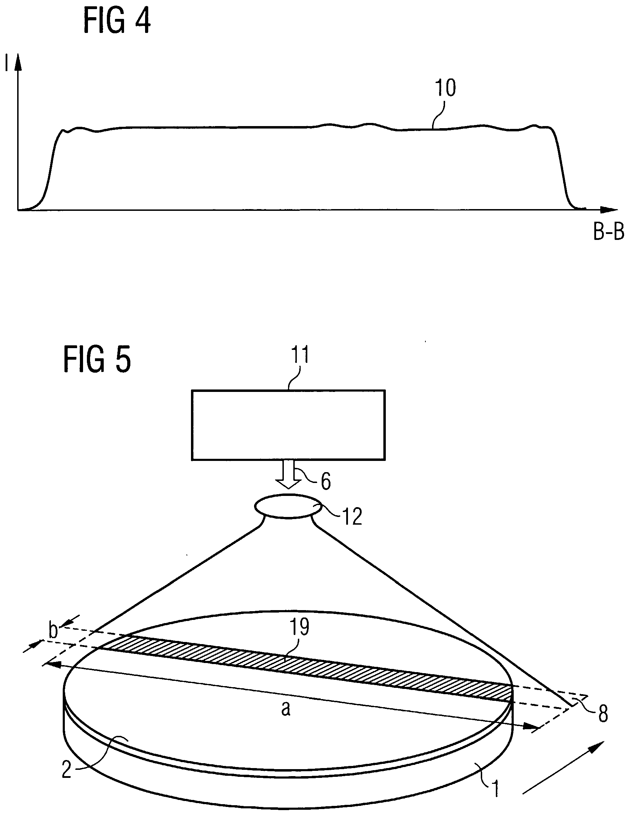

Die hieraus bei der in Figur 2a gezeigten Einzelbestrahlung der Halbleiterschicht resultierende Intensitätsverteilung ist in Figur 4 dargestellt. Aufgetragen ist die über die gesamte Bestrahlungszeit integrierte Intensität längs der Linie B-B.

Es ergibt sich ein weitgehend homogener, nahezu konstanter Intensitätsverlauf über die gesamte Fläche der Halbleiterschicht 2, der eine rückstandsfreie Trennung der Halbleiterschicht 2 von dem Substrat 1 ermöglicht.

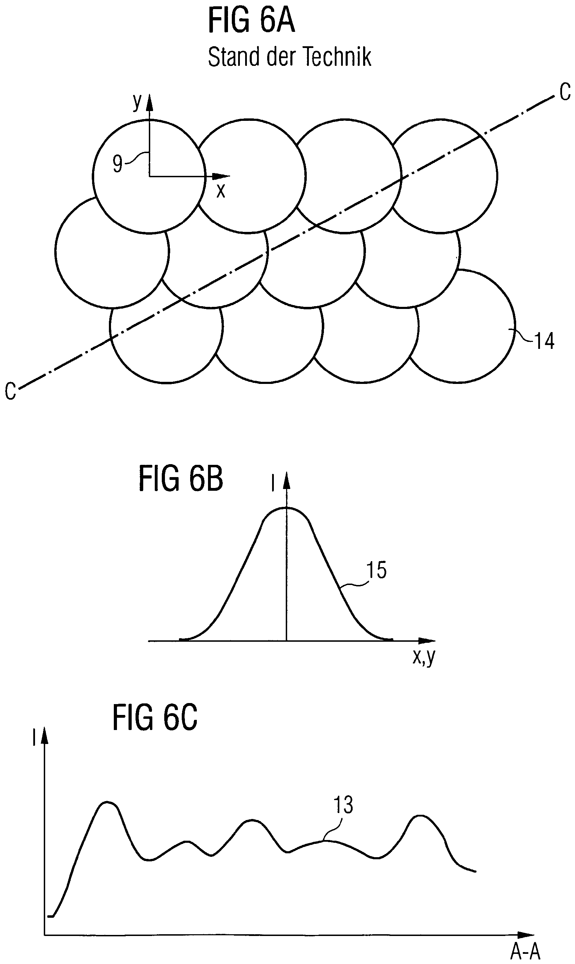

In Figur 6 ist demgegenüber bezüglich des Strahlprofils ein entsprechendes Verfahren nach dem Stand der Technik dargestellt. Der hierbei verwendete Laser, beispielsweise ein frequenzverdreifachter Nd:YAG-Laser weist eine näherungsweise kreisförmige Strahlfläche mit einem gaußförmigen Strahlprofil 15 auf.

Eine Figur 2a bzw. 2b entsprechende rasterartige Anordnung nacheinander bestrahlter Bereiche 14 einer Halbleiterschicht ist in Figur 6a gezeigt.

Das zugehörige Strahlprofil 15, d.h. der Intensitätsverlauf längs der X-Achse bzw. der Y-Achse des Achsenkreuzes 9 ist in Figur 6b dargestellt. Aufgrund einer rotationssymmetrischen Intensitätsverteilung, aus der sich auch die kreisförmige Strahlfläche ergibt, ist der Intensitätsverlauf entlang der beiden Achsen näherungsweise gleich. Der Intensitätsverlauf entspricht einer Gaußkurve mit maximaler Intensität im Ursprung des Achsenkreuzes 9.

Um mit einem solchen Laserstrahl die Dekompositionsschwelle zu erreichen, ist in der Regel eine Fokussierung des Strahls erforderlich. Die Dekompositionsschwelle wird dabei im Strahlzentrum überschritten, während in den Randbereichen die Energiedichte für eine Materialzersetzung zu gering ist. Bei einer rasterartigen Bestrahlung einer Halbleiterschicht gemäß Figur 6a ist eine näherungsweise konstante Intensitätsverteilung, wie sie in Figur 4 dargestellt ist, nicht erzielbar. Die Intensitätsvariation über das gesamte Strahlprofil und insbesondere das ausgeprägte Intensitätsmaximum im Strahlzentrum führt zu zahlreichen Intensitätsmaxima und -minima auf der Halbleiterschicht.

Ein beispielhafter Verlauf 13 der über die gesamte Bestrahlungszeit integrierten Intensität längs der in Figur 6a gezeigten Linie C-C ist in Figur 6c dargestellt ist. Die Variation des Intensitätsverlaufs 13 führt zu einer ungleichmäßigen Materialzersetzung, wobei insbesondere in den Minima der Intensitätsverteilung die Dekompositionsschwelle unterschritten werden kann.

An den Stellen, an denen die für die Materialzersetzung nötige Energiedichte nicht erreicht wird, bleibt das Halbleitermaterial erhalten. Aufgrund der Materialzersetzung in der Umgebung dieser Stellen, gegebenenfalls mit Gasentwicklung wie beispielsweise Stickstoff im Fall von Nitridverbindungshalbleitern, kann lokal ein hoher Druck entstehen, durch den Partikel aus dem Substrat herausgerissen werden. Diese Partikel können an den Stellen des nicht zersetzten Halbleitermaterials haften bleiben, so daß letztendlich Substratrückstände auf der abgelösten Halbleiterschicht zurückbleiben.

Um dem vorzubeugen, könnte bei herkömmlichen Verfahren die Strahlintensität weiter gesteigert werden. Dann bestünde aber die Gefahr einer Beschädigung der Halbleiterschicht durch Überhitzung an den Stellen der Intensitätsmaxima.

In Figur 5 ist ein drittes Ausführungsbeispiel eines erfindungsgemäßen Verfahrens dargestellt. Im Unterschied zu dem in Figur 1 und 2 gezeigten Verfahren wird hier der Laserstrahl so auf die Halbleiterschicht 2 abgebildet, daß eine streifenförmige Strahlfläche 19 entsteht. Die Strahlfläche 19 weist dabei eine Längsabmessung a und eine Querabmessung b auf, wobei die Längsabmessung a deutlich größer als die Querabmessung b ist. Eine entsprechende Strahlfläche kann bei einem Excimer-Laser 11 beispielsweise mittels einer geeigneten Maskenoptik 12 ausgebildet werden. Vorzugsweise ist die Längsabmessung a größer als eine entsprechende Abmessung der Halbleiterschicht 2, so daß die Halbleiterschicht 2 in dieser Richtung vollständig bestrahlt wird. Der Intensitätsabfall in den Flankenbereichen 18 des Strahlprofils wirkt sich dabei nicht auf das Trennverfahren aus, da die Flankenbereiche 18 außerhalb der Halbleiterschicht 2 liegen.

Die Halbleiterschicht 2 wird während der Bestrahlung in Richtung der Querabmessung b bewegt, so daß die gesamte Halbleiterschicht 2 gleichmäßig bestrahlt wird. Bei einem gepulsten Laser mit hinreichend kurzer Impulsdauer, typischerweise im Nanosekundenbereich, ergibt sich dabei wieder eine sukzessive Bestrahlung von streifenförmigen Einzelflächen auf der Halbleiterschicht 2, da Halbleiterschicht 2 im wesentlichen zwischen den Laserimpulses weiterbewegt wird und die Bestrahlung dieser Bewegung gegenüber instant erfolgt.

**Patentansprüche**

1. Verfahren zur Herstellung eines strahlungserzeugenden Halbleiterbauelements, bei dem eine Halbleiterschicht (2) von einem Substrat (1) durch Bestrahlen mit einem Excimer-Laserstrahl (6) getrennt wird, wobei

   - vor der Trennung von dem Substrat (1) die Halbleiterschicht (2) mit der von dem Substrat (1) abgewandten Seite auf einen Träger (4) aufgebracht wird,

   **dadurch gekennzeichnet, daß**

   - der thermische Ausdehnungskoeffizient des Trägers $a_T$ auf das Strahlprofil und/oder die Pulslänge der Laserstrahlpulse und auf den thermischen Ausdehnungskoeffizienten der Halbleiterschicht $a_{HL}$ und den thermischen Ausdehnungskoeffizienten $a_S$ des Substrats derart abgestimmt gewählt wird, dass Verspannungen zwischen Substrat, Halbleiterschicht und Träger während der Herstellung reduziert werden, so dass in dem bei der Herstellung auftretenden bzw. im Betrieb vorgesehenen Temperaturbereich keine Schäden an der Halbleiterschicht und dem Träger entstehen, und
sich der thermische Ausdehnungskoeffizient des Trägers $a_T$ um 35% oder weniger von dem thermischen Ausdehnungskoeffizienten $a_{HL}$ der Halbleiterschicht unterscheidet,
   - der Träger Molybdän oder Wolfram enthält.

2. Verfahren nach dem obigen Anspruch, **dadurch gekennzeichnet, daß** der thermische Ausdehnungskoeffizient des Trägers $a_T$ näher an dem thermischen Ausdehnungskoeffizienten der Halbleiterschicht $a_{HL}$ als an dem thermischen Ausdehnungskoeffizienten $a_S$ des Substrats gewählt wird.

3. Verfahren nach einem der obigen Ansprüche, **dadurch gekennzeichnet, daß** sich der thermische Ausdehnungskoeffizient des Trägers $a_T$ um 45% oder weniger von dem thermischen Ausdehnungskoeffizienten $a_S$ des Substrat unterscheidet.

4. Verfahren nach dem vorherigen Anspruch, **dadurch gekennzeichnet, daß** sich der thermische Ausdehnungskoeffizient des Trägers $a_T$ um 40% oder weniger von dem thermischen Ausdehnungskoeffizienten $a_S$ des Substrats unterscheidet.

5. Verfahren nach einem der obigen Ansprüche, **dadurch gekennzeichnet, daß** der Träger einen thermischen Ausdehnungskoeffizienten zwischen $4{,}3 * 10^{-6}$ K$^{-1}$ und $5{,}9 * 10^{-6}$ K$^{-1}$ aufweist.

6. Verfahren nach dem vorherigen Anspruch, **dadurch gekennzeichnet , daß** der Träger einen thermischen Ausdehnungskoeffizienten zwischen $4{,}6 * 10^{-6}$ K$^{-1}$ und $5{,}3 * 10^{-6}$ K$^{-1}$ aufweist.

7. Verfahren nach einem der obigen Ansprüche, **dadurch gekennzeichnet, daß** für die Trennung der Halbleiterschicht von dem Substrat eine Pulslänge der Laserstrahlpulse größer als 15 ns gewählt wird.

8. Verfahren nach einem der obigen Ansprüche **dadurch gekennzeichnet, daß** die Halbleiterschicht (2) auf den Träger (4) gelötet wird.

9. Verfahren nach dem vorherigen Anspruch, **dadurch gekennzeichnet, daß**

die Halbleiterschicht (2) mittels eines Lots, das Gold und/oder Zinn oder Palladium und/oder Indium enthält, auf den Träger (4) gelötet wird.

**10.** Verfahren nach einem der obigen Ansprüche, d**adurch gekennzeichnet**, daß vor dem Verbinden der Halbleiterschicht (2) mit dem Träger (4) auf die von dem Substrat (1) abgewandte Seite der Halbleiter (2) eine Metallisierung aufgebracht wird.

**11.** Verfahren nach dem vorherigen Anspruch, **dadurch gekennzeichnet, daß** die Metallisierung Gold und/oder Platin enthält.

**12.** Verfahren nach einem der obigen Ansprüche, **dadurch gekennzeichnet, daß** die Halbleiterschicht (2) eine Mehrzahl von Einzelschichten umfasst.

**13.** Verfahren nach einem der obigen Ansprüche **dadurch gekennzeichnet , daß** die Halbleiterschicht (2) bzw. mindestens eine der Einzelschichten einen Nitridverbindungshalbleiter enthält.

**14.** Verfahren nach dem vorherigen Anspruch, **dadurch gekennzeichnet, daß** der Nitridverbindungshalbleiter eine Nitridverbindung von Elementen der dritten und/oder fünften Hauptgruppe ist.

**15.** Verfahren nach einem der Ansprüche 13 oder 14, **dadurch gekennzeichnet, daß** die Halbleiterschicht (2) bzw. mindestens eine der Einzelschichten $In_xAl_yGa_{1-x-y}N$ mit $0 \leq x \leq 1$, $0 \leq y \leq 1$ und $x+y \leq 1$, enthält.

**16.** Verfahren nach dem vorherigen Anspruch, **dadurch gekennzeichnet, daß** die Halbleiterschicht (2) bzw. mindestens eine der Einzelschichten GaN, AlGaN, InGaN, AlInGaN, AlN oder InN enthält.

**17.** Verfahren nach einem der obigen Ansprüche, **dadurch gekennzeichnet, daß** das Substrat (1) Silizium, Siliziumkarbid oder Aluminiumoxid, insbesondere Saphir, enthält.

**18.** Verfahren nach einem der obigen Ansprüche, **dadurch gekennzeichnet, daß** die Halbleiterschicht (2) mittels eines Epitaxieverfahrens auf das Substrat (1) aufgebracht wird.

**19.** Verfahren nach einem der obigen Ansprüche, **dadurch gekennzeichnet, daß** die Halbleiterschicht (2) eine Dicke aufweist, die kleiner oder gleich 50 $\mu$m ist.

**20.** Verfahren nach einem der obigen Ansprüche, **dadurch gekennzeichnet, daß** das Halbleiterbauelement eine Lumineszenzdiode ist.

**21.** Verfahren nach einem der obigen Ansprüche, **dadurch gekennzeichnet, daß** das Halbleiterbauelement eine Leuchtdiode ist.

**Claims**

**1.** Method of manufacturing a radiation-generating semiconductor device, wherein a semiconductor layer (2) is separated from a substrate (1) by irradiation with an excimer laser beam (6), wherein

  - before separation from the substrate (1), the semiconductor layer (2) is applied to a carrier (4) with the side facing away from the substrate (1),

**characterized in that**

  - the thermal expansion coefficient of the carrier $a_T$ is selected to be adapted to the beam profile and/or the pulse length of the laser beam pulses and to the thermal expansion coefficient of the semiconductor layer $a_{HL}$ and to the thermal expansion coefficient $a_S$ of the substrate in such a way that stresses between substrate, semiconductor layer and carrier are reduced during manufacture so that no damage is caused to the semiconductor layer and the carrier in the temperature range occurring during manufacture or provided for during operation, and

the thermal expansion coefficient of the carrier $a_T$ differs by 35% or less from the thermal expansion coefficient $a_{HL}$ of the semiconductor layer,

  - the carrier contains molybdenum or tungsten.

**2.** Method according to the above claim, **characterized in that** the thermal expansion coefficient of the carrier $a_T$ is chosen closer to the thermal expansion coefficient of the semiconductor layer $a_{HL}$ than to the thermal expansion coefficient $a_S$ of the substrate.

**3.** Method according to any of the above claims, **characterized in that** the coefficient of thermal expansion of the carrier $a_T$ differs by 45% or less from the coefficient of thermal expansion $a_S$ of the substrate.

**4.** Method according to the previous claim, **characterized in that**

the thermal expansion coefficient of the carrier $a_T$ differs by 40% or less from the thermal expansion coefficient $a_S$ of the substrate.

5. Method according to any of the above claims, **characterized in that** the carrier has a coefficient of thermal expansion between $4.3 * 10^{-6}\ K^{-1}$ and $5.9 * 10^{-6}\ K^{-1}$.

6. Method according to the previous claim, **characterized in that** the carrier has a coefficient of thermal expansion between $4.6 * 10^{-6}\ K^{-1}$ and $5.3 * 10^{-6}\ K^{-1}$.

7. Method according to any of the above claims, **characterized in that** a pulse length of the laser beam pulses greater than 15 ns is selected for the separation of the semiconductor layer from the substrate.

8. Method according to any of the above claims **characterized in that** the semiconductor layer (2) is soldered onto the carrier (4).

9. Method according to the previous claim, **characterized in that** the semiconductor layer (2) is soldered to the carrier (4) by means of a solder containing gold and/or tin or palladium and/or indium.

10. Method according to any of the above claims, **characterized in that** a metallization is applied to the side of the semiconductor (2) facing away from the substrate (1) before the semiconductor layer (2) is connected to the carrier (4).

11. Method according to the previous claim, **characterized in that** the metallization contains gold and/or platinum.

12. Method according to any of the above claims, **characterized in that** the semiconductor layer (2) comprises a plurality of individual layers.

13. Method according to any of the above claims **characterized in that** the semiconductor layer (2) or at least one of the individual layers contains a nitride compound semiconductor.

14. Method according to the previous claim, **characterized in that** the nitride compound semiconductor is a nitride compound of elements of the third and/or fifth main group.

15. Method according to any of claims 13 or 14, **characterized in that** the semiconductor layer (2) or at least one of the individual layers contains $In_xAl_yGa_{1-x-y}N$ with $0 \leq x \leq 1$, $0 \leq y \leq 1$ and $x+y \leq 1$.

16. Method according to the previous claim, **characterized in that** the semiconductor layer (2) or at least one of the individual layers contains GaN, AlGaN, InGaN, AlInGaN, AlN or InN.

17. Method according to any of the above claims, **characterized in that** the substrate (1) contains silicon, silicon carbide or aluminium oxide, in particular sapphire.

18. Method according to any of the above claims, **characterized in that** the semiconductor layer (2) is applied to the substrate (1) by means of an epitaxy process.

19. Method according to any of the above claims, **characterized in that** the semiconductor layer (2) has a thickness which is less than or equal to 50 $\mu$m.

20. Method according to any of the above claims, **characterized in that** the semiconductor device is a luminescent diode.

21. Method according to any of the above claims, **characterized in that** the semiconductor device is a light emitting diode.

**Revendications**

1. Méthode de fabrication d'un dispositif semi-conducteur générateur de rayonnement, dans lequel une couche semi-conductrice (2) est séparée d'un substrat (1) par irradiation avec un faisceau laser à excimère (6), dans lequel

   - avant la séparation du substrat (1), la couche semi-conductrice (2) est appliquée sur un support (4) avec le côté opposé au substrat (1),

   **caractérisé par le fait que**

   - le coefficient de dilatation thermique du support $a_T$ est choisi de manière à correspondre au profil du faisceau et/ou à la longueur des impulsions du faisceau laser et au coefficient de dilatation thermique de la couche semi-conductrice $a_{HL}$ et au coefficient de dilatation thermique $a_S$ du substrat, de telle sorte que les contraintes entre le substrat, la couche semi-conductrice et le support soient réduites pendant la fabrication, de sorte qu'aucun dommage ne soit causé à la couche semi-conductrice et au support dans la plage de températures survenant pendant la fabrication ou prévue pendant le fonctionnement, et

le coefficient de dilatation thermique du support $a_T$ diffère de 35 % ou moins du coefficient de dilatation thermique $a_{HL}$ de la couche semi-conductrice,

- le support contient du molybdène ou du tungstène.

**2.** Méthode selon la revendication ci-dessus, **caractérisé par le fait que** le coefficient de dilatation thermique du support $a_T$ est choisi plus proche du coefficient de dilatation thermique de la couche semi-conductrice $a_{HL}$ que du coefficient de dilatation thermique $a_S$ du substrat.

**3.** Méthode selon l'une des revendications ci-dessus, **caractérisé par le fait que** le coefficient de dilatation thermique du support $a_T$ diffère de 45 % ou moins du coefficient de dilatation thermique $a_S$ du substrat.

**4.** Méthode selon la revendication précédente, **caractérisé par le fait que** le coefficient de dilatation thermique du support $a_T$ diffère de 40% ou moins du coefficient de dilatation thermique $a_S$ du substrat.

**5.** Méthode selon l'une des revendications ci-dessus, **caractérisé par le fait que** le support a un coefficient de dilatation thermique compris entre 4,3 * 10$^{-6}$ K$^{-1}$ et 5,9 * 10$^{-6}$ K$^{-1}$.

**6.** Méthode selon la revendication précédente, **caractérisé par le fait que** le support a un coefficient de dilatation thermique compris entre 4,6 * 10$^{-6}$ K$^{-1}$ et 5,3 * 10$^{-6}$ K$^{-1}$.

**7.** Méthode selon l'une des revendications ci-dessus, **caractérisé par le fait que** une longueur d'impulsion du faisceau laser supérieure à 15 ns est choisie pour la séparation de la couche semi-conductrice du substrat.

**8.** Méthode selon l'une des revendications ci-dessus **caractérisé par le fait que** la couche semi-conductrice (2) est soudée sur le support (4).

**9.** Méthode selon la revendication précédente, **caractérisé par le fait que** la couche semi-conductrice (2) est soudée au support (4) au moyen d'une soudure contenant de l'or et/ou de l'étain ou du palladium et/ou de l'indium.

**10.** Méthode selon l'une des revendications ci-dessus, **caractérisé par le fait que** une métallisation est appliquée sur la face du semi-conducteur (2) opposée au substrat (1) avant que la couche semi-conductrice (2) ne soit reliée au support (4).

**11.** Méthode selon la revendication précédente, **caractérisé par le fait que** la métallisation contient de l'or et/ou du platine.

**12.** Méthode selon l'une des revendications ci-dessus, **caractérisé par le fait que** la couche semi-conductrice (2) comprend une pluralité de couches individuelles.

**13.** Méthode selon l'une des revendications ci-dessus **caractérisé par le fait que** la couche semi-conductrice (2) ou au moins une des couches individuelles contient un semi-conducteur composé de nitrure.

**14.** Méthode selon la revendication précédente, **caractérisé par le fait que** le semi-conducteur composé de nitrure est un composé de nitrure d'éléments du troisième et/ou cinquième groupe principal.

**15.** Méthode selon l'une des revendications 13 ou 14, **caractérisé par le fait que** la couche semi-conductrice (2) ou au moins une des couches individuelles contient $In_xAl_yGa_{1-x-y}N$ avec $0 \leq x \leq 1$, $0 \leq y \leq 1$ et $x+y \leq 1$.

**16.** Méthode selon la revendication précédente, **caractérisé par le fait que** la couche semi-conductrice (2) ou au moins une des couches individuelles contient du GaN, de l'AlGaN, de l'InGaN, de l'AlInGaN, de l'AlN ou de l'InN.

**17.** Méthode selon l'une des revendications ci-dessus, **caractérisé par le fait que** le substrat (1) contient du silicium, du carbure de silicium ou de l'oxyde d'aluminium, en particulier du saphir.

**18.** Méthode selon l'une des revendications ci-dessus, **caractérisé par le fait que** la couche semi-conductrice (2) est appliquée sur le substrat (1) au moyen d'un procédé d'épitaxie.

**19.** Méthode selon l'une des revendications ci-dessus, **caractérisé par le fait que** la couche semi-conductrice (2) a une épaisseur inférieure ou égale à 50 $\mu$m.

**20.** Méthode selon l'une des revendications ci-dessus, **caractérisé par le fait que** le dispositif semi-conducteur est une diode luminescente.

**21.** Méthode selon l'une des revendications ci-dessus, **caractérisé par le fait que** le dispositif à semi-conducteur est une diode électroluminescente.

## FIG 1A

## FIG 1B

## FIG 1C

## FIG 1D

## FIG 1E

## FIG 2A

## FIG 2B

## FIG 3A

18a　　　17a　　　18a

7a

x

## FIG 3B

18b　17b　18b

7b

y

## FIG 4

## FIG 5

# FIG 6A

Stand der Technik

# FIG 6B

# FIG 6C

**FIG 7**

**FIG 8**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9814986 A

- JP 2000196197 A

**In der Beschreibung aufgeführte Nicht-Patentliteratur**

- **DRUCKSCHRIFT WONG et al.** *Appl. Phys. Lett.,* vol. 75 (13), 1887-1889